(19) Europäisches Patentamt

European Patent Office

Office européen des brevets

(11) **EP 4 746 665 A1**

(12) **DEMANDE DE BREVET EUROPEEN**

(43) Date de publication:
20.05.2026   Bulletin 2026/21

(21) Numéro de dépôt: 25215345.7

(22) Date de dépôt: **12.11.2025**

(51) Classification Internationale des Brevets (IPC):
*H10N 10/17* (2023.01)     *H10N 10/817* (2023.01)
*H10N 10/852* (2023.01)    *H10N 10/851* (2023.01)
*B33Y 80/00* (2015.01)

(52) Classification Coopérative des Brevets (CPC):
**H10N 10/817; B33Y 80/00; H10N 10/17;
H10N 10/852; H10N 10/8556;** B22F 10/25;
B22F 12/55

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH LA MA MD TN**

(30) Priorité:  **14.11.2024   FR 2412441**

(71) Demandeur: **Commissariat à l'Energie Atomique
et aux Energies
Alternatives
75015 Paris (FR)**

(72) Inventeurs:
• **SAVELLI, Guillaume
38054 GRENOBLE (FR)**
• **BAUDRY, Maxime
38054 GRENOBLE (FR)**
• **ROUX, Guilhem
38054 GRENOBLE (FR)**

(74) Mandataire: **Ipsilon
12, Avenue d'Italie
75013 Paris (FR)**

(54) **MODULE THERMOÉLECTRIQUE À JONCTION PN**

(57)   Module thermoélectrique (10), comprenant,
- un substrat (20),
- au moins deux éléments thermoélectriques (11, 12) adjacents en deux matériaux dopés selon des types de dopages différents s'étendant sur le substrat et reliés électriquement entre eux du côté du substrat (20) et/ou opposé au substrat (20) par une jonction électrique de mélange formée par une couche d'un mélange des deux matériaux dopés selon des types de dopages différents composants les deux éléments thermoélectriques (11, 12).

[Fig 1]

Fig. 1

EP 4 746 665 A1

## Description

## Domaine technique

La présente invention concerne un module thermoélectrique.

## Technique antérieure

De manière connue, les modules thermoélectriques sont généralement constitués de matériaux dopés de type p et de type n, et comporte des plots agencés sur un substrat. Les plots sont connectés électriquement en série par des jonctions métalliques et thermiquement en parallèle.

Les performances électriques d'un dispositif thermoélectrique en mode générateur sont données par :

a) Une résistance électrique interne Rint de jonction entre les matériaux dopés de type p et de type n déterminée de la manière suivante :

$$Rint = N \text{ x } \rho_{np} \text{ x } H/A + Rc + Rmet$$

Avec N le nombre de jonctions entre les matériaux dopés de type p et type n de la structure, $\rho_{np}$ est la densité de charges au niveau des jonctions p-n, H la longueur d'une ligne ou d'un plot, A la section d'une ligne ou d'un plot Rc la résistance totale des contacts et Rmet la résistance totale des jonctions métalliques,

b) Une puissance électrique utile Pu = $V^2$/4Rint.

Pour disposer d'une puissance électrique utile élevée, il faut donc avoir notamment une résistance électrique Rint faible et donc limiter la contribution à la résistance des résistances totales des contacts Rc et la résistance totale des jonctions métalliques.

La fabrication de modules thermoélectriques est généralement réalisée à partir de plusieurs étapes : la fabrication de matériaux thermoélectriques notamment par frittage, la mise en forme des plots, leur métallisation et l'assemblage avec le substrat. Les jonctions entre les différents plots de dopages différents se font classiquement par des connexions électriques sous forme de ruban ou dépôt métallique entre les plots.

Il est connu de EP3985745 un procédé de fabrication de dispositif thermoélectrique. Le procédé inclut plusieurs étapes parmi lesquelles la fabrication de pièces en forme de peigne, leur assemblage mécanique et électrique, suivi de la découpe pour former les jonctions thermoélectriques.

FR3140994 concerne un procédé de fabrication de structures thermoélectriques utilisant des techniques de fabrication additive telles que la fusion laser sur lit de poudres ou le frittage sélectif par laser et peut inclure une étape de retrait du substrat pour obtenir la structure finale.

FR3140993 décrit également un procédé de fabrication de structures thermoélectriques utilisant également des techniques de fabrication additives, de préférence la fusion laser sur lit de poudre ou de frittage sélectif par laser. Ces procédés de fabrication nécessitent des étapes d'assemblage et ne permettent pas de fabriquer des dispositifs thermoélectriques sur des surfaces de formes complexes.

L'article J. Lee, S. Choo, H. Ju, J. Hong, S. E. Yang, F. Kim, D. H. Gu, J. Jang, G. Kim, S. Ahn, J. E. Lee, S. Y. Kim, H. G. Chae, J. S. Son, Doping-Induced Viscoelasticity in PbTe Thermoelectric Inks for 3D Printing of Power-Generating Tubes. Adv. Energy Mater. 2021, 11, 2100190. décrit des modules thermoélectriques fabriqué par une méthode de fabrication additive, notamment par solution printing, une méthode d'impression 3D. Des particules PbTe sont synthétisées, puis des encres colloïdales sont réalisées à partir de ces particules. Les encres sont ensuite extrudées à l'aide d'une imprimante 3D, puis séchés et traités thermiquement. Les objets obtenus sont ensuite assemblés pour former des modules thermoélectriques.

L'article Hue et al. ACS Applied Materials and Interfaces 2023, Vol 15/Issue 32, 3D Printing of Bi2Te3-Based Thermoelectric Materials with High Performance and Shape Controllability décrit également des modules thermoélectriques fabriqué par une méthode de fabrication additive, en particulier par fusion sélective au laser, pour obtenir des modules thermoélectriques en forme de demi-anneaux.

Dans tous ces arts antérieurs, les éléments thermoélectriques sous forme de plots de dopages différents sont reliés électriquement entre eux par des connexions métalliques de types rubans.

Il existe donc un besoin de développer un nouveau module thermoélectrique ayant des performances thermoélectriques satisfaisantes, facile à fabriquer et permettant une grande versatilité d'application et d'utilisation.

## Exposé de l'invention

La présente invention répond à ce besoin grâce à un module thermoélectrique comprenant,

- un substrat,
- au moins deux éléments thermoélectriques adjacents en deux matériaux dopés selon des types de dopages différents s'étendant sur le substrat et reliés électriquement entre eux du côté du substrat et/ou opposé au substrat par une jonction électrique de mélange formée par une couche d'un mélange des deux matériaux dopés selon des types de dopages différents composants les deux éléments thermoélectriques.

L'invention concerne également un procédé de fabrication d'un module thermoélectrique tel que mentionné ci-dessus.

Une telle jonction électrique de mélange permet une connexion électrique performante se faisant entre les deux éléments thermoélectriques sans qu'il ne soit nécessaire d'ajouter des éléments de connexions métalliques. Cela permet donc de faciliter la fabrication du module et d'avoir des performances thermoélectriques satisfaisantes.

De préférence les éléments thermoélectriques et la jonction électrique de mélange sont formés par dépôt sous énergie concentrée.

L'utilisation d'une méthode de dépôt sous énergie concentrée permet de réaliser des dépôts sur une grande quantité de types de forme de substrat, notamment sur des substrats cylindriques, ce qui n'est pas possible ou complexe avec d'autres procédés de fabrication additive comme la fusion laser sur lit de poudre. Cela permet de construire des modules directement sur des substrats adaptés à la forme de la source thermique, notamment de chaleur ou de froid, facilitant la fabrication de tels modules et améliorant ainsi les rendements.

Ainsi, le dépôt sous énergie concentrée permet la fabrication de modules de formes complexes, comme des modules cylindriques, qui peuvent être plus adaptés à certaines sources de chaleur à dissiper.

Par ailleurs, la technique de dépôt sous énergie concentrée peut se faire avec une pluralité de buses émettant de la poudre des matériaux à déposer vers la zone de fusion comme nous le verrons par la suite. Le fait qu'il y ait plusieurs buses permet d'envisager le dépôt de matériaux différents par les différentes buses. Cela permet notamment de former les éléments thermoélectriques dopées p et les éléments thermoélectriques dopées n sans avoir à changer la poudre dans le dispositif, à partir de buses différentes. Cela simplifie la fabrication et améliore la précision de fabrication et de jonction entre les deux matériaux. Cela peut améliorer les performances énergétiques du module thermoélectrique, notamment en diminuant les résistances électriques aux jonctions.

Le dépôt sous énergie concentrée permet également d'avoir une grande versatilité de formes d'unités thermoélectriques réalisables. Cela permet une grande versatilité de configuration des modules thermoélectriques et de leurs performances et ainsi de pouvoir fabriquer un module thermoélectrique sur mesure en fonction des performances recherchées, de la forme et de l'encombrement disponible. Certaines formes d'éléments thermoélectriques peuvent en particulier améliorer l'encombrement des éléments thermoélectriques dans un module, permettant une meilleure optimisation de l'espace dans le module thermoélectrique et ainsi d'améliorer les performances du module pour un même encombrement.

Il est ainsi possible selon la situation, notamment le cahier des charges et l'environnement d'avoir des modules variés dont la forme et les dimensions des modules sont adaptées à chaque situation.

Le dépôt sous énergie concentrée permet également une grande versatilité de schéma électrique entre les éléments thermoélectriques, notamment de relier les éléments thermoélectriques en série ou en parallèle pour adapter les performances.

## Jonction électrique

Le module peut comporter un circuit thermoélectrique comportant une pluralité d'éléments thermoélectriques adjacents reliés électriquement entre eux par des jonctions électriques dont au moins une est une jonction électrique de mélange, les éléments thermoélectriques reliés entre eux étant en des matériaux de dopages différents. De préférence, toutes les jonctions électriques du côté du substrat et/ou du côté opposé au substrat sont des jonctions électriques de mélange. Dans un mode de réalisation, toutes les jonctions électriques sont des jonctions électriques de mélange. En variante, toutes les jonctions électriques de l'un du côté du substrat et du côté opposé au substrat sont des jonctions électriques de mélange et toutes les jonctions électriques de l'autre du côté du substrat et du côté opposé au substrat sont formées par des jonctions métalliques, notamment des bandes métalliques.

La ou les jonctions électriques de mélange peuvent s'étendre entre deux surfaces latérales des éléments thermoélectriques en regard.

La surface de la jonction électrique de mélange selon un plan médian aux deux éléments thermoélectriques reliés entre eux par ladite jonction électrique de mélange peut présenter une aire supérieure ou égale à 50%, mieux supérieure ou égale à 70%, de l'aire d'une section transversale d'un élément thermoélectrique.

## Eléments thermoélectriques

De préférence, les éléments thermoélectriques adjacents reliés entre eux par une jonction électrique de mélange sont de structures sensiblement identiques à l'exception du dopage. De préférence, les éléments thermoélectriques reliés entre eux par une jonction électrique de mélange sont en des matériaux identiques dopés différemment. De préférence, tous les éléments thermoélectriques sont en des matériaux identiques dopés différemment.

En variante, les éléments thermoélectriques reliés entre eux par une jonction électrique de mélange sont en des matériaux thermoélectriques différents dopés différemment. Dans ce cas, les éléments électriques des matériaux thermoélectriques différents dopés différemment peuvent alterner le long du circuit thermoélectrique.

De préférence, les éléments thermoélectriques adjacents sont reliés à des éléments thermoélectriques distincts à leurs extrémités. Dans ce cas, les éléments thermoélectriques sont reliés entre eux en série. Les éléments thermoélectriques peuvent être reliés électriquement en série entre eux de l'un du côté du substrat et du côté opposé au substrat uniquement.

En variante, au moins deux éléments thermoélectriques peuvent être reliés électriquement entre eux par du côté du substrat et du côté opposé au substrat. Dans ce cas, le circuit comporte des éléments reliés électriquement entre eux en parallèle.

Au moins un, mieux, les éléments thermoélectriques, peuvent être chacun monocouche.

En variante, au moins un, mieux les éléments thermoélectriques, sont multicouches. Ils peuvent comporter plusieurs couches de matériaux différents dopés avec le même type de dopage. Cela peut permettre d'avoir des propriétés mécaniques, notamment compatibilité thermique plus large en ayant une combinaison de matériaux thermoélectriques adaptée à des plages de températures différentes.

De préférence, les couches de matériaux différents dopés peuvent être séparées entre elles par une ou plusieurs structures d'interface.

La ou les structures d'interface peuvent comporter au moins une couche en un matériau formant une barrière de diffusion, notamment en cuivre ou nickel. De tels matériaux d'interface permettent de limiter la diffusion entre les deux éléments thermoélectriques, d'avoir un bon contact électrique, notamment peu résistif et de limiter les problèmes de dilatations thermiques entre les deux éléments thermoélectriques.

La structure d'interface peut être multicouche et comporter la couche en un matériau formant une barrière de diffusion en sandwich entre deux couches en un matériau thermoélectrique différent des matériaux thermoélectriques qu'elle sépare.

De préférence, dans ce cas, les éléments thermoélectriques sont identiques.

Les éléments thermoélectriques peuvent être composés d'un ou de plusieurs plots de même dopage. De préférence, les éléments thermoélectriques sont composés d'un seul plot. En variante, les éléments thermoélectriques sont composés de plusieurs plots, ces derniers étant de même dopage et reliés électriquement à la fois du côté du substrat et du côté opposé au substrat, les plots étant alors connectés en parallèle entre eux.

## Matériau

Les éléments thermoélectriques peuvent être en silicium (Si), en un alliage de silicium et germanium (SiGe), tellurure de bismuth (Bi2Te3), skuttérudites, en un alliage Half Heusler ou en Tellurure de plomb.

## Agencement des éléments thermoélectriques entre eux

Les éléments thermoélectriques peuvent être inclinés sur le substrat par rapport à l'axe perpendiculaire du substrat à leur base.

De préférence, les éléments thermoélectriques reliés entre eux par une jonction électrique de mélange sont inclinés sur le substrat par rapport à l'axe perpendiculaire du substrat à leur base dans des directions opposées. Ils peuvent être inclinés par rapport à l'axe perpendiculaire du substrat à leur base d'un même angle $\alpha$, notamment compris entre 5° et 70°. L'angle peut dépendre notamment des performances thermoélectriques attendues, de la tenue mécanique nécessaire, des matériaux et/ou de la hauteur des éléments. Dans le cas d'un substrat de forme cylindrique de section circulaire, l'angle $\alpha$ peut-être sensiblement égal à 720/n, n étant le nombre d'élément thermoélectriques agencées autour d'une section transversale du substrat.

## Forme des éléments thermoélectriques

Les éléments thermoélectriques sont chacun de préférence allongés selon un axe longitudinal.

De préférence, les éléments thermoélectriques sont chacun symétriques par rapport à leur axe longitudinal.

Les éléments thermoélectriques peuvent être chacun symétriques par rapport à leur axe médian perpendiculaire à l'axe longitudinal. En variante, les éléments thermoélectriques sont chacun asymétriques par rapport audit axe médian.

Les éléments thermoélectriques peuvent tous être sensiblement de même forme.

Dans le cas d'éléments thermoélectriques asymétriques par rapport à leur axe médian. Les éléments thermoélectriques reliés entre eux par une jonction électrique de mélange peuvent être de formes complémentaires, notamment sensiblement imbriquables entre eux. Cela permet notamment un rapprochement des éléments thermoélectriques, ce qui réduit l'encombrement et permet d'avoir une plus grande quantité d'éléments thermoélectriques par unité de surface. En variante, les éléments thermoélectriques reliés entre eux par une jonction électrique de mélange peuvent être agencés dans le même sens.

En variante, au moins deux éléments thermoélectriques sont de formes différentes, notamment les éléments thermoélectriques reliés entre eux par une jonction électrique de mélange sont de formes différentes, notamment complémentaires.

Les éléments thermoélectriques peuvent être de forme cylindrique à base quelconque avec une surface latérale s'étendant sur le substrat. La base du cylindre peut avoir la forme d'un quadrilatère, notamment d'un rectangle ou d'un trapèze isocèle, d'un sablier symétrique ou non par rapport au plan médian, d'un secteur circulaire sous forme de plots de forme sensiblement parallélépipédique ou présenter une surface à leur base inférieure ou égale

Les éléments thermoélectriques peuvent présenter, entre la base et le sommet, un rétrécissement localisé présentant une largeur latérale inférieure à la largeur du sommet et/ou de la base.

Les éléments thermoélectriques peuvent présenter une surface à leur base différente de la surface à leur sommet, notamment une des deux surfaces peut être plus grande que l'autre pour un contour sensiblement identique ou inversement.

Les éléments thermoélectriques peuvent comporter des branches s'étendant vers la base et/ou le sommet. Les branches peuvent être inclinées entre elles. Les branches peuvent se rejoindre à leur base. Les éléments thermoélectriques peuvent être en forme de Y ou de X. En variante, les branches sont distantes entre elles sur toute leur hauteur.

Les éléments thermoélectriques peuvent être creux ou pleins.

Les éléments thermoélectriques peuvent comporter des évidements, notamment des encoches latérales sur leur hauteur ou un évidement à leur base ou leur sommet. Cela permet notamment d'alléger le module thermoélectrique, de réduire la quantité de matière utilisée et d'augmenter la différence de température entre le sommet et la base des éléments thermoélectriques en condition de fonctionnement.

La base des éléments thermoélectriques peut être de forme complémentaire du substrat, notamment être une surface courbe dans le cas d'un substrat cylindrique à base circulaire ayant le même rayon de courbure que le substrat.

Le sommet des éléments thermoélectriques peut être une surface plane ou courbe. La surface courbe du sommet peut être de même rayon de courbure que le substrat.

**Méthode de dépôt sous énergie concentrée**

Le dépôt sous énergie concentrée peut être effectué à l'aide d'un dispositif comportant une unique buse de projection de matière à déposer ou une pluralité de buses de projection de matière à déposer. Comme mentionné précédemment, le fait qu'il y ait plusieurs buses permet d'envisager le dépôt de matériaux différents par les différentes buses. Cela permet notamment de former les éléments thermoélectriques dopés p et les éléments thermoélectriques dopés n sans avoir à changer la poudre dans le dispositif, à partir de buses différentes. Cela simplifie la fabrication et améliore la précision de fabrication et de jonction. Cela peut améliorer les performances énergétiques du module thermoélectrique, notamment en diminuant les résistances électriques aux jonctions électriques internes et/ou externes.

**Dépôt simultané**

Dans le cas d'une pluralité de buses de projection, au moins deux buses peuvent être reliées à des réservoirs distincts, notamment chaque buse étant reliée à un réservoir qui lui est propre. Dans ce cas, les buses reliées à des réservoirs distincts peuvent être alimentées en matériau issu du réservoir de façon indépendante.

De préférence, dans ce cas, au moins une ou plusieurs premières buses sont reliées à un ou plusieurs réservoirs contenant un matériau dopé de type n pour former un des éléments thermoélectriques reliés entre eux par une jonction électrique de mélange au moins en partie et au moins une ou plusieurs autres deuxièmes buses sont reliées à un ou plusieurs réservoirs contenant un matériau dopé de type p pour former l'autre des éléments thermoélectriques reliés entre eux par une jonction électrique de mélange au moins en partie.

La ou les premières et la ou les deuxièmes buses peuvent être commandées de façon indépendante ou synchronisée pour ne déposer qu'un seul des deux matériaux ou un mélange des deux matériaux. Cela permet de limiter les manipulations du dispositif de dépôt pour la formation du module thermoélectrique, les matériaux dopés différemment pour les éléments thermoélectriques pouvant être introduits en amont dans le dispositif de dépôt et le dépôt pouvant se faire par programmation sans intervention extérieure. Cela permet également d'améliorer la précision de positionnement des éléments thermoélectriques et notamment de réaliser des jonctions électriques de mélange avec une plus grande précision et donc une meilleure qualité de connexion.

Il est ainsi possible de déposer uniquement le matériau de type p, notamment pour former un élément thermoélectrique au moins en partie, ou uniquement le matériau de type n, notamment pour former l'autre élément thermoélectrique au moins en partie, ou de déposer un mélange des matériaux de type n et p, pour former la jonction électrique de mélange entre les éléments thermoélectriques. Ainsi, le dépôt des deux éléments thermoélectriques peut se faire au moins en partie par projection de deux matériaux dopés selon des types de dopage différents par des buses différentes du dispositif de dépôt sous énergie concentrée. Ainsi, la ou les jonctions électriques de mélange peuvent être formées entre deux éléments thermoélectriques par le dépôt simultané des deux matériaux de dopages différents par la ou les premières et la ou les deuxièmes buses.

La formation des éléments thermoélectriques peut se faire au moins en partie par le dépôt alterné d'un matériau dopé de type p et d'un matériau dopé de type n en alternant la projection de matière par la ou les premières buses et la ou les deuxièmes buses. Cela permet notamment de fabriquer au moins partiellement le module sans avoir à manipuler le dispositif de dépôt et cela permet un meilleur repérage des éléments thermoélectriques entre eux.

L'alternance des projections par le ou les premières buses et par le ou les deuxièmes buses telle que décrite précédemment peut comporter des plages de recoupement de la projection de matière par la ou les premières buses et la ou les deuxièmes buses pour former les jonctions électriques de mélange telles que décrits précédemment. Cela permet notamment d'avoir des connexions électriques formées durant le processus de dépôt des éléments thermoélectriques au moins en partie par continuité de matière et en particulier de s'affranchir des connexions par pistes métalliques additionnelles.

Dans le cas d'élément thermoélectriques multicouches, le procédé peut comporter

(a) le dépôt sous énergie concentrée de la base des éléments thermoélectriques en un premier matériau avec optionnellement les jonctions électrique de mélange à la base sur le support ou sur des pistes conductrices comme décrit précédemment,
(b) le dépôt par toute méthode adaptée de la structure d'interface sur les parties des éléments thermoélectriques formés puis,
(c) le dépôt par dépôt sous énergie concentrée du sommet des éléments thermoélectriques en un deuxième matériau différent du premier avec optionnellement les jonctions électriques de mélange au sommet des éléments thermoélectriques comme décrit précédemment.

Dans le cas de couches intermédiaires supplémentaires en un matériau thermoélectriques, le procédé peut comporter additionnellement entre les étapes b) et c), autant de fois qu'il y a de couches intermédiaires, le dépôt sous énergie concentrée de la couche des éléments thermoélectriques en un matériau additionnel sur la structure d'interface déposée précédemment comme décrit précédemment puis le dépôt par toute méthode adaptée d'une structure d'interface sur les parties des éléments thermoélectriques formés précédemment.

Le procédé peut comporter le changement de matériau dans les réservoirs du dispositif de dépôt sous énergie concentrée pour chaque étape de dépôt. En variante, le dispositif peut comporter au moins autant de réservoirs que de matériaux nécessaires au dépôt sous énergie concentrée et les différentes étapes de dépôt ci-dessus se font avec des buses différentes.

### Dépôt successif

En variante, toutes les buses peuvent être reliées à un même réservoir de matière à déposer. Il est alors nécessaire de changer le matériau pour chaque nouveau matériau et chaque type de dopage. Le procédé peut comporter au moins une étape de changement du matériau à déposer dans le dispositif de dépôt sous énergie concentrée.

En variante encore, la formation des éléments thermoélectriques peut se faire par dépôt des différents matériaux et différents dopages l'un après l'autre selon la structure des éléments thermoélectriques. Dans le cas d'éléments thermoélectriques en un unique et même matériau, le procédé peut comporter dans une première étape le dépôt de tous les éléments thermoélectriques dopés de type p puis le dépôt de tous les éléments thermoélectriques dopés de type n dans une deuxième étape. Le dépôt de la jonction électrique de mélange peut se faire de façon indépendante dans une ou plusieurs étapes additionnelles chacune avant, ou après la première étape et avant ou après la deuxième étape. Cela peut se faire par changement du matériau à déposer dans le dispositif de dépôt sous énergie concentrée, dans le cas notamment d'un unique réservoir pour toutes les buses, et/ou par commande du dépôt par des buses différentes.

### Formation des pistes électriques

Le procédé peut comporter une étape de dépôt de pistes métalliques sur le substrat et/ou sur les éléments thermoélectriques pour former une partie des jonctions électriques internes et/ou externes.

Le procédé peut comporter le dépôt sur le substrat, préalablement au dépôt des éléments thermoélectriques, d'une couche métallique discontinue pour former au moins une partie des jonctions électriques du côté du substrat sous la forme de pistes conductrices.

Le procédé peut comporter le dépôt sur les éléments thermoélectriques, après le dépôt des éléments thermoélectriques, d'une couche métallique discontinue pour former au moins une partie des jonctions électriques du côté opposé au substrat sous la forme de pistes conductrices.

### Substrat

Le substrat est préférentiellement en un matériau isolant. Il peut être en céramique, notamment en AIN, mullite, CN.

Le substrat peut être de forme cylindrique de base polygonale, notamment rectangle, carré, pentagonale ou hexagonale, circulaire ou elliptique.

En variante, le substrat peut être d'une autre forme, notamment former une surface plane ou bombée ou encore une surface plus complexe.

### Circuit thermoélectrique

Le module peut comporter une pluralité d'éléments thermoélectriques adjacents reliés électriquement entre eux pour former un circuit thermoélectrique, chaque élément thermoélectrique étant reliés électriquement du côté du substrat et/ou opposé au substrat à un autre élément thermoélectrique par une jonction électrique formée par une couche d'un mélange des deux matériaux dopés selon des types de dopages différents composant les deux éléments thermoélectriques.

De préférence, le module forme un circuit thermoélectrique entre un premier élément thermoélectrique et un dernier élément thermoélectrique, le premier et le dernier élément thermoélectrique étant reliés électriquement par une de leurs extrémités à un connecteur électrique et les éléments thermoélectriques entre le premier et le dernier élément thermoélectrique étant tous reliés électriquement à au moins deux éléments thermoélectriques adjacents pour former entre eux le circuit thermoélectrique par des jonctions électriques formées par une couche d'un mélange des deux matériaux dopés selon des types de dopages différents composant les deux éléments thermoélectriques. .

En variante, le module forme un circuit thermoélectrique entre un premier élément thermoélectrique et un dernier élément thermoélectrique, le premier et le dernier élément thermoélectrique étant reliés électriquement par une de leurs extrémités à un connecteur électrique et les éléments thermoélectriques entre le premier et le dernier élément thermoélectrique étant tous reliés électriquement à au moins deux éléments thermoélectriques adjacents pour former entre eux le circuit thermoélectrique par un connecteur électrique d'un côté du substrat ou du côté opposé au substrat et par une jonction électrique formée par une couche d'un mélange des deux matériaux dopés selon des types différents de dopages différents composant les deux éléments thermoélectriques de l'autre côté du côté du substrat ou du côté opposé au substrat.

Dans le cas d'un substrat de forme cylindrique, les éléments thermoélectriques peuvent être agencés selon des rangées circonférentielles dans lesquelles les éléments thermoélectriques sont électriquement reliés entre eux, deux éléments thermoélectriques de chaque rangée circonférentielle étant reliés électriquement à un élément thermoélectrique le plus proche d'une rangée antérieure et d'une rangée postérieure le long de l'axe longitudinal du substrat respectivement à l'exception de la première et dernière rangée circonférentielle qui sont chacune reliées à un connecteur électrique.

En variante, les éléments thermoélectriques peuvent être agencés selon des rangées longitudinales dans lesquelles les éléments thermoélectriques sont électriquement reliés entre eux, le premier et le dernier élément thermoélectrique de chaque rangée longitudinale étant reliés électriquement aux éléments thermoélectriques les plus proches des rangées longitudinales adjacentes à l'exception de deux rangées longitudinales adjacentes chacune reliées à un connecteur électrique.

**Structure support**

Le procédé peut comporter le dépôt d'une structure support sur le substrat, la structure support comportant des éléments supports configurés pour s'étendre entre les éléments thermoélectriques formant un pont entre eux et servir de support au dépôt des éléments thermoélectriques durant le dépôt sous énergie concentrée de ces derniers. Ce dépôt se fait de préférence préalablement au dépôt des éléments thermoélectriques sous énergie concentrée.

Les éléments supports peuvent comporter un matériau isolant électriquement et/ou un matériau sacrificiel.

Dans le cas d'éléments thermoélectriques inclinés par rapport à l'axe perpendiculaire au substrat à leur base, les éléments supports peuvent s'étendre sous les éléments thermoélectriques. Cela permet de faciliter le dépôt des éléments thermoélectriques par le dépôt sous énergie concentrée.

Dans le cas d'éléments thermoélectriques en contact l'un avec l'autre, les éléments supports peuvent s'étendre entre les éléments TE en contact entre eux à leur sommet.

De préférence, les éléments supports sont tous identiques et en un même matériau.

Ils peuvent être déposés par toute méthode adaptée sur le substrat, notamment par impression 3D, notamment par la méthode de dépôt sous énergie concentré. Au moins une des buses du dispositif de dépôt sous énergie concentrée peut être connectée à un réservoir contenant le matériau constituant les éléments supports.

Les éléments supports peuvent être de conductivité thermique inférieure ou égale à celle des éléments thermoélectriques.

Les éléments supports peuvent être en un matériau isolant électriquement. Le matériau isolant électriquement peut être une céramique, notamment en silice, mica ou Macor®. La céramique peut être pleine ou poreuse.

En variante, les éléments supports sont en un matériau sacrificiel, le procédé comportant en outre une étape de retrait du matériau sacrificiel par une méthode appropriée, notamment par voie chimique ou par chauffage. Le matériau sacrificiel peut être en céramique ou métal, notamment en silice ou en nitrure d'aluminium. Ainsi, il est possible d'avoir des éléments supports uniquement apparent durant le procédé de fabrication mais qui ne sont plus apparent sur le module thermoélectrique et forment des zones creuses.

En variante, les éléments supports peuvent comporter une structure plus complexe, notamment comporter une couche de peau et une couche de cœur. La couche de peau peut être en un matériau isolant électriquement et la couche de cœur en un matériau sacrificiel.

**Etapes additionnelles**

Le procédé peut comporter, après formation des éléments thermoélectriques et des jonctions électriques de mélange, une étape de recuit. L'étape de recuit peut comporter la chauffe du module formé à une température supérieure ou égale à supérieure ou égale à 100°C dans un four sous atmosphère inerte, notamment d'Argon. Un tel recuit permet notamment de modifier la microstructure des éléments thermoélectriques et de la jonction électrique de mélange pour améliorer la microstructure du module formé. Cela peut permettre en outre de réduire les contraintes mécaniques accumulées dans le module durant la fabrication et donc d'améliorer les propriétés mécaniques et thermoélectriques du module thermoélectrique.

## Brève description des dessins

[Fig 1] représente schématiquement en coupe transversale un exemple de module thermoélectrique cylindrique,

[Fig 2] représente schématiquement en coupe une variante de module thermoélectrique,

[Fig 3] représente schématiquement une variante de module thermoélectrique,

[Fig 4] représente schématiquement différentes variantes de formes de plots thermoélectriques,

[Fig 5] représente schématiquement en coupe transversale une variante de module thermoélectrique,

[Fig 6] représente schématiquement en coupe transversale une variante de module thermoélectrique,

[Fig 7] représente schématiquement en coupe transversale une variante d'unité thermoélectrique,

[Fig 8] représente schématiquement un exemple de procédé,

[Fig 9] représente schématiquement une variante de procédé.

[Fig 10] représente schématiquement une variante de procédé,

[Fig 11] représente schématiquement un exemple de structure de support, et

[Fig 12] représente schématiquement une variante de procédé.

## Description détaillée

Dans la suite de la description, les éléments identiques ou de fonctions identiques 10 portent le même signe de référence. A des fins de concision de la présente description, ils ne sont pas décrits en regard de chacune des figures, seules les différences entre les modes de réalisation étant décrites.

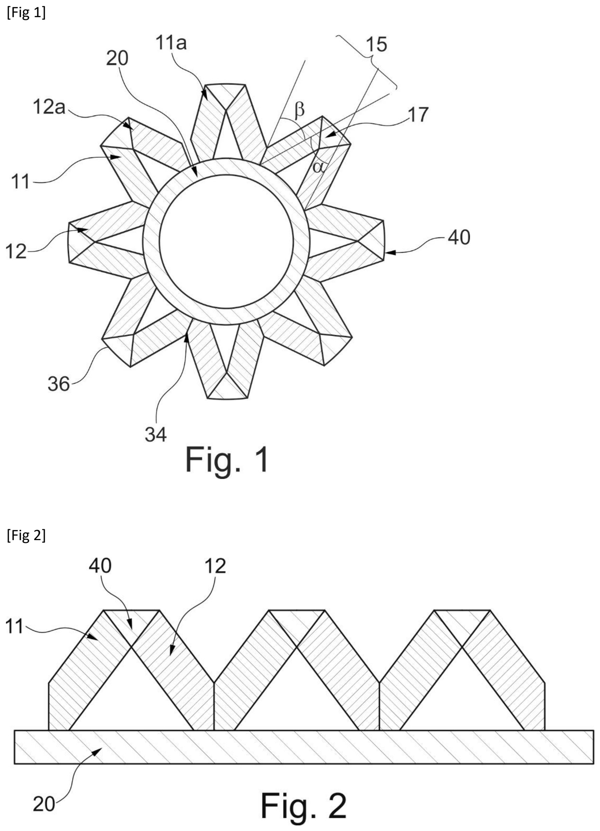

On a illustré à la figure 1 un module thermoélectrique (10), comportant un substrat (20) cylindrique à base circulaire, portant des éléments thermoélectriques (11, 12) reliés entre eux électriquement par des jonctions électriques (32, 31). Le substrat est préférentiellement en un matériau isolant. Il peut être en céramique, notamment en AIN, mullite, CN.

Les éléments thermoélectriques (11, 12) reliés électriquement entre eux sont de dopages différents de sorte que les éléments thermoélectriques (11, 12) soient de dopages alternés sur le substrat (20).

Dans le mode de réalisation de la figure 1, les éléments thermoélectriques (11, 12) sont de formes identiques. L'invention n'est pas limitée à des éléments thermoélectriques (11, 12) de formes identiques. Ces derniers pourraient présenter des formes différentes ou être de formes identiques mais agencées tête-bêche comme nous le verrons par la suite.

Les éléments thermoélectriques (11, 12) sont ici chacun sous forme de plots allongés selon un axe d'élongation. Au moins l'une des jonctions électriques de la base (32) ou du sommet (31) est une jonction électrique de mélange formée par un mélange des deux matériaux des éléments thermoélectriques qu'elle relie. De préférence, toutes les jonctions électriques de la base des éléments thermoélectriques (32) et/ou toutes les jonctions électriques du sommet des éléments thermoélectriques (31) sont des jonctions électriques de mélange.

Toutes les jonctions électriques de la base des éléments thermoélectriques (32) et de toutes les jonctions électriques du sommet des éléments thermoélectriques (31) peuvent être des jonctions électriques de mélange. En variante, l'une de toutes les jonctions électriques de la base des éléments thermoélectriques (32) et de toutes les jonctions électriques du sommet des éléments thermoélectriques (31) sont des jonctions électriques de mélange et l'autre de toutes les jonctions électriques de la base des éléments thermoélectriques (32) et de toutes les jonctions électriques du sommet des éléments thermoélectriques (31) sont des pistes métalliques formés par une couche métallique discontinue déposée sur les éléments thermoélectriques (11, 12) ou sur le substrat (20).

Dans l'exemple illustré, les éléments thermoélectriques (11, 12) ont des axes d'élongation différents d'un axe radial en formant entre eux un angle $\alpha$ compris entre 5° et 70°. L'angle $\alpha$ est sensiblement égal à 720/n, n étant le nombre d'éléments thermoélectriques agencés autour d'une section transversale du substrat, ici sensiblement égal à 45°. Dans ce cas, la surface de contact (17) entre les éléments thermoélectriques est de préférence supérieure ou égale à 50% de la section transversale d'un élément thermoélectrique. Chaque élément thermoélectrique peut former un angle $\beta$ avec l'axe radial à la base sensiblement égal à l'angle $\alpha$. Dans l'exemple illustré tous les éléments thermoélectriques forment le même angle avec l'axe radial. Cependant, il pourrait en être autrement, en particulier les éléments thermoélectriques d'un dopage pourraient former un premier angle et les éléments thermoélectriques de l'autre dopage former un deuxième angle différent du premier avec leur axe radial. Dans ce mode de réalisation, les éléments thermoélectriques sont reliés entre eux par contact à leur base et par un mélange des matières composant les deux éléments thermoélectriques (11, 12) à leur sommet comme cela est visible plus en détail en figure 2 représenté à plat. Cette jonction (40) peut être formée par l'utilisation d'un dispositif à dépôt sous énergie concentrée comportant plusieurs buses reliées à des réservoirs différents contenant le matériau dopé p et le matériau dopée n respectivement et par projection simultanée des deux matériaux à la jonction entre les deux éléments thermoélectriques (11, 12). Le procédé de fabrication peut alors comporter une séquence de projections coordonnées avec le déplacement des buses sur le substrat comportant une première projection d'un matériau d'un premier dopage pour former un premier élément thermoélectrique (11) par la ou les premières buses, puis une deuxième projection d'un matériau d'un deuxième dopage pour former un deuxième élément thermoélectrique (12) par la ou les deuxièmes buses, la première et la deuxième projection étant simultanée à la jonction entre les deux éléments thermoélectriques (11, 12) pour former la jonction (40) par mélange des deux matériaux. De préférence, les matériaux formant les éléments thermoélectriques sont identiques. Seul leur dopage change.

Les éléments thermoélectriques peuvent être en matériaux thermoélectriques, tels que le silicium (Si), en un alliage de silicium et germanium (SiGe), tellurure de bismuth (Bi2Te3), skuttérudites, en un alliage Half Heusler ou en Tellurure de plomb. Chaque élément thermoélectrique (11, 12) est relié par son sommet par une jonction électrique (31) à un élément thermoélectrique (11, 12) adjacent et à sa base par une jonction électrique (32) à un autre élément thermoélectrique (11, 12) adjacent, de sorte à former un circuit thermoélectrique autour et sur le substrat (20).

Dans ce mode de réalisation, les éléments thermoélectriques (11, 12) sont reliés entre eux en séries, chaque élément thermoélectrique (11, 12), à l'exception du premier et du dernier élément thermoélectrique de la série, étant relié à sa base à un élément thermoélectrique adjacent par une des jonctions électriques (32) et à son sommet à un autre élément thermoélectrique adjacent par une des jonctions électriques (31). Le premier et le dernier élément thermoélectrique de la série sont reliés chacun à un élément thermoélectrique adjacent par l'un de leur base et de leur sommet et à un connecteur électrique vers l'extérieur, non représenté, par l'autre de leur base et de leur sommet. Les éléments thermoélectriques (11, 12) peuvent être agencés selon des rangées circonférentielles dans lesquelles les éléments thermoélectriques sont électriquement reliés entre eux par les jonctions électriques (31, 32), deux éléments thermoélectriques (11a, 12a) de chaque rangée circonférentielle étant reliés électriquement à un élément thermoélectrique le plus proche d'une rangée antérieure et d'une rangée postérieure le long de l'axe longitudinal du substrat respectivement à l'exception de la première et dernière rangée circonférentielle qui sont chacune reliées à un connecteur électrique.

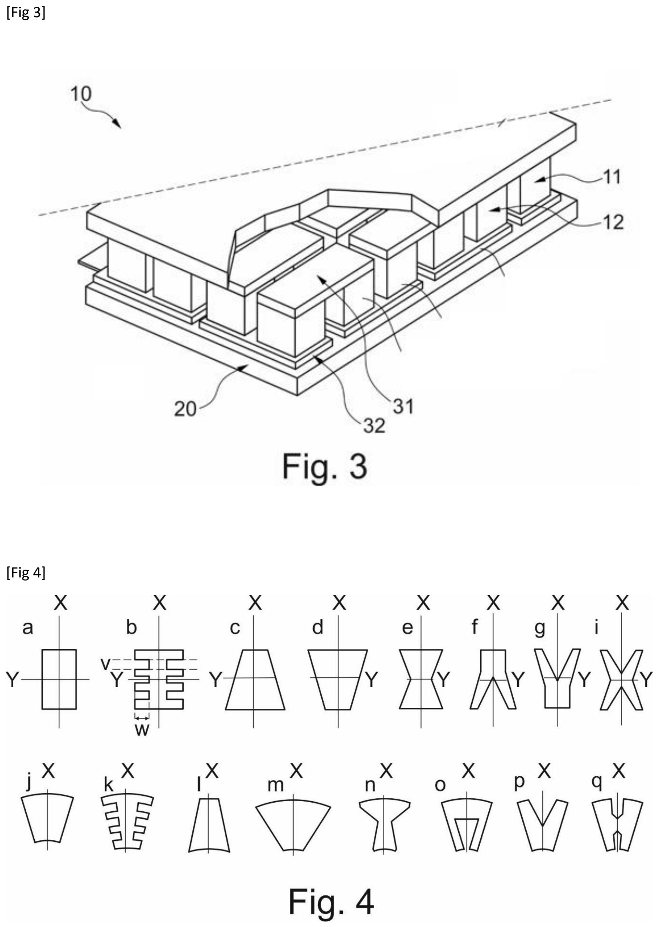

Le module thermoélectrique (10) de la figure 3 diffère des précédents modules illustrés en ce que les éléments thermoélectriques ne sont plus inclinés par rapport au support et le support est plan et la jonction à la base ou au sommet est un mélange des deux matières pour faire une connexion plane.

L'invention n'est pas limitée à une forme des éléments thermoélectriques (11, 12) particulières. De nombreuses variantes de formes peuvent être envisagées. La figure 4 en présente quelques-unes. Sur la ligne supérieure, allant de a à i, les formes correspondent à des éléments thermoélectriques déposés sur une surface du substrat (20) plane et sur la ligne inférieure, allant de j à q, à des éléments thermoélectriques déposés sur une surface courbée du substrat (20). Néanmoins, les formes de la ligne supérieure sont adaptées à un dépôt sur une surface courbe moyennant l'adaptation de la base et les formes de la ligne inférieure moyennant quelques petites adaptations à la portée de l'homme du métier. Les éléments thermoélectriques s'étendent de préférence selon un axe longitudinal (X). Les éléments thermoélectriques a, b, e, i sont symétriques par rapport à leur plan médian perpendiculaire à leur axe longitudinal (X). Les éléments thermoélectriques c, d, f, g ne sont pas symétriques par rapport à leur plan médian (Y) perpendiculaire à l'axe longitudinal X. L'élément thermoélectrique b, présente des évidements latéraux, d'une épaisseur v et d'une profondeur w. Les éléments thermoélectriques c et d présentent chacun des surfaces à leur base et à leur sommet différentes. Les éléments thermoélectriques c et d sont de formes complémentaires et peuvent être alignés de façon alternée pour rapprocher les éléments thermoélectriques. L'élément thermoélectrique e, présente entre son sommet et sa base une largeur latérale inférieure à la largeur du sommet et de la base, étant en forme de sablier. Les éléments thermoélectriques f, g et i possèdent des branches qui s'étendent vers la base pour l'élément f, vers le sommet pour l'élément g et vers le sommet et la base pour l'élément i, en forme de X.

Les éléments thermoélectriques i, j, k, l, m, n, o, p, q correspondent aux éléments a, b, c, d, e, f, g, h, adaptés à une surface de contact du substrat courbe sur lequel ils sont déposés. Dans ce cas-ci, le substrat possède une surface courbe et les éléments thermoélectriques possèdent de préférence à leur base et à leur sommet le même rayon de courbure que le substrat.

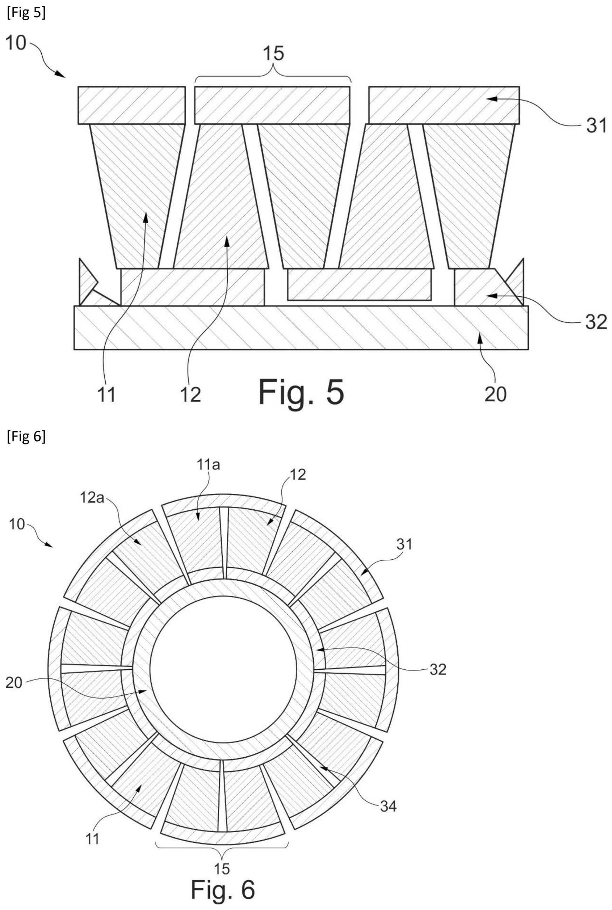

On a illustré à la figure 5, un module thermoélectrique (10) dont la surface du substrat (20) est plane. Les éléments thermoélectriques (11, 12) dopés différemment sont de formes différentes. Deux éléments thermoélectriques adjacents comportent un élément thermoélectrique (11) de forme trapézoïdale avec le grand côté formant la base et un élément thermoélectrique (11) de forme trapézoïdale avec le grand côté formant le sommet. Les éléments thermoélectriques (11, 12) présentent des surfaces latérales de formes complémentaires.

En variante illustré sur la figure 6, les éléments thermoélectriques (11, 12) sont ici chacun sous forme de plot allongé selon un axe longitudinal, correspondant à un axe radial du substrat (20) et sont symétriques par rapport à cet axe longitudinal. Les éléments thermoélectriques (11, 12) sont de largeur croissante le long de l'axe longitudinal de leur base vers leur sommet. Ils présentent en section transversale du substrat des parois latérales (34) rectilignes s'étendant chacune radialement au substrat (20). Cela permet de limiter les espaces vides entre les éléments thermoélectriques (31, 32).

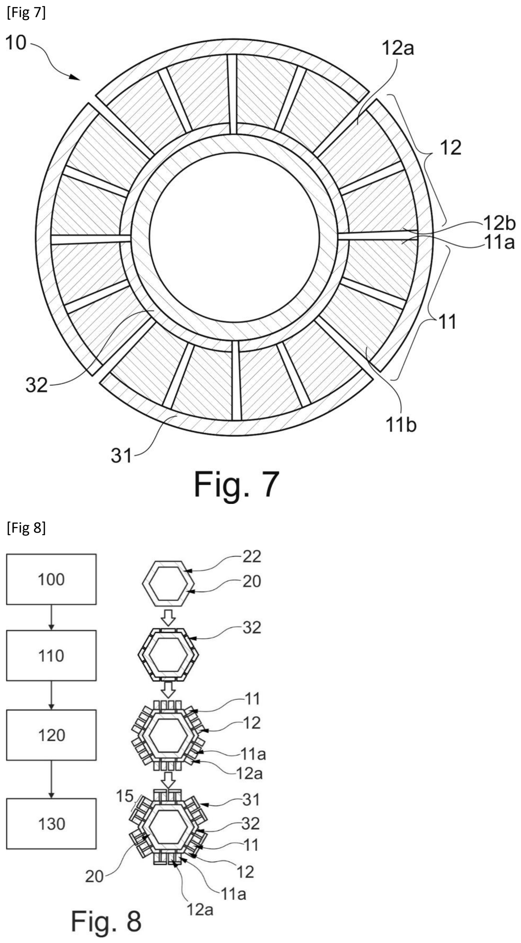

On a illustré à la Figure 7, une variante d'un module thermoélectrique (10), dans laquelle, le premier élément thermoélectrique (11) et le deuxième élément thermoélectrique (12) sont formés chacun de deux plots (11a, 11b; 12a, 12b) de même dopage, préférentiellement en un même matériau. Les deux plots de chaque élément sont reliés électriquement entre eux du côté du substrat et du côté opposé au substrat en parallèle. Ces jonctions peuvent être formées par continuité de matière ou par des connecteurs électriques métalliques. Les éléments thermoélectriques (11, 12) de dopages différents sont quant à eux reliés de façon alternée autour du substrat entre eux du côté opposé au substrat (31) et du côté du substrat (32). Au moins l'une des jonctions électriques entre éléments thermoélectriques du côté du substrat et du côté opposé au substrat est formé par un mélange de la matière des deux éléments thermoélectriques adjacents. L'invention n'est pas limitée à un ou deux plots par éléments thermoélectriques. Les éléments thermoélectriques peuvent comporter plus de deux plots selon les performances recherchées et le cahier des charges. L'invention n'est également pas limitée à un même nombre de plots pour les deux éléments thermoélectriques. Le premier élément pourrait par exemple avoir un unique plot et le deuxième élément avoir deux plots.

On a illustré à la figure 8, un procédé de fabrication d'une variante de module thermoélectrique (10). Le module thermoélectrique (10) formé est similaire à celui de la figure 7. Les seules différences sont que le substrat (20) est hexagonal en section et non circulaire comme cela est le cas sur la figure 7 et que les éléments thermoélectriques (11, 12) sont de forme parallélépipédique et donc de largeur constante sur toute leur hauteur. Chaque face (22) du substrat porte une ou plusieurs paires d'éléments thermoélectriques adjacents (11, 12), ici deux paires d'éléments thermoélectriques adjacents (11, 12). Les paires d'éléments thermoélectriques adjacents (11, 12) de bases différentes sont reliées entre elles par des jonctions (32) à leur base s'étendant entre les deux faces correspondantes. Dans ce mode de réalisation les paires d'éléments thermoélectriques adjacents sont chacune sur une face. Néanmoins, il est possible, sans sortir du cadre de cette invention d'avoir une ou plusieurs paires d'éléments thermoélectriques adjacents (11, 12) à cheval sur deux faces adjacentes.

Dans ce procédé de fabrication, la première étape (100) consiste à fournir le substrat (20) sur lequel est déposé les jonctions électriques (32) dans une seconde étape (110). Le dépôt des jonctions électriques peut être réalisé en une ou plusieurs couches par toute méthode de dépôt.

Les éléments thermoélectriques (11, 12) sont ensuite déposés en étape (120) sur les connexions électriques (32). Le dépôt des éléments thermoélectriques (11, 12) est réalisé par une méthode de dépôt sous énergie concentrée à l'aide d'un dispositif adapté.

Le dispositif de dépôt sous énergie concentrée peut comporter une pluralité de buses dont au moins une ou des premières buses sont reliées à un réservoir de poudre en un matériau dopé p et une ou des deuxièmes buses sont reliées à un réservoir de poudre dopée n. Le dépôt des éléments thermoélectriques (11, 12) peut alors se faire par dépôts successifs des éléments thermoélectriques (11, 12) adjacents sur les jonctions électriques (32). La ou les premières buses peuvent alors projeter le matériau dopé p pour former un élément thermoélectrique (11), puis la ou les deuxièmes premières buses peuvent projeter le matériau dopé n pour former un élément thermoélectrique (12) adjacent, et ainsi de suite jusqu'à former l'intégralité des éléments thermoélectriques (11, 12). En variante, l'étape de dépôt comporte le dépôt de tous les éléments thermoélectriques d'un dopage puis le dépôt de tous les éléments thermoélectriques de l'autre dopage.

En variante, le dispositif de dépôt sous énergie concentrée comporte une unique buse ou toutes ses buses sont reliées à un ou plusieurs réservoirs contenant un matériau d'un dopage. Le procédé de dépôt est alors similaire à celui décrit précédemment sauf qu'il faut changer le ou les réservoirs et/ou le ou les contenus des réservoirs pour pouvoir procéder au dépôt des éléments thermoélectriques des deux dopages.

Enfin en étape 130, les jonctions électriques (31) sont formées par mélange des matières des deux éléments thermoélectriques adjacents sur les éléments thermoélectriques (11,12) pour connecter les éléments thermoélectriques entre eux à leurs sommets, dans le cas présent pour connecter les éléments thermoélectriques adjacents (11, 12) entre eux.

Le procédé peut comporter, après formation des éléments thermoélectriques adjacents (11, 12), une étape additionnelle de recuit non illustré. L'étape de recuit peut comporter la chauffe du module formé à une température supérieure ou égale à 100°C sous atmosphère inerte, notamment d'Argon.

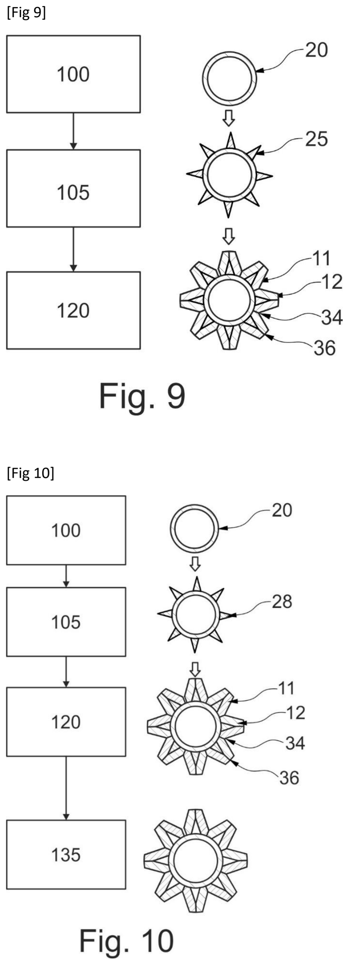

On a illustré à la figure 9, un procédé de fabrication d'un module (10), comportant la fourniture d'un substrat (20) selon l'étape 100, puis à l'étape 105 le dépôt d'une structure support (25) sur le substrat (20), suivi du dépôt des éléments thermoélectriques (11, 12) par dépôt d'énergie concentrée sous la même forme qu'à la figure 1, c'est-à-dire par jonction mélange. La structure support (25) comporte des éléments supports déposés à intervalle régulier sur le substrat (20) qui facilitent la fabrication des éléments thermoélectriques inclinés par rapport à l'axe radial en permettant leur formation directement sur la surface de ces structures supports (25). De préférence les structures supports (25) sont de forme complémentaire des espaces sous les éléments thermoélectriques, notamment triangulaire. Le dépôt de la structure support peut se faire par tout moyen connus. De préférence, de tels éléments supports peuvent être de conductivité thermique inférieure ou égale à celle des éléments thermoélectriques (11, 12), notamment en un matériau isolant, par exemple en céramique ou silice, pleine ou poreuse.

On a illustré à la figure 10, un procédé de fabrication d'un module thermoélectrique (10) similaire à celui de la figure 9. Dans ce mode de réalisation, la structure support est formée d'éléments sacrificiels (28) en un matériau sacrificiel. Le procédé peut comporter alors une étape 135 de retrait du matériau sacrificiel par une méthode appropriée, notamment par voie chimique ou par chauffage. Le matériau sacrificiel peut être en céramique ou métal, notamment en silice ou en nitrure d'aluminium.

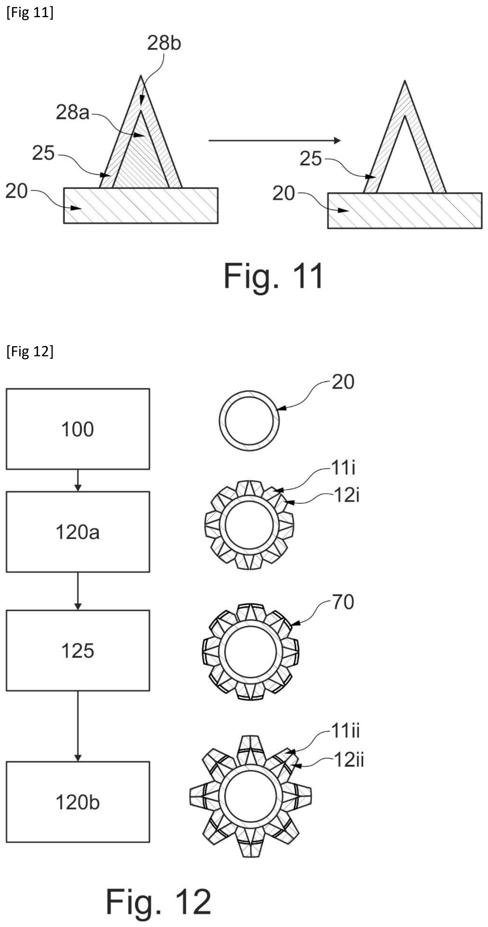

En variante illustrée sur la figure 11, la structure support comporte d'une partie interne (28a) en un matériau sacrificiel et une partie externe (28b) en un matériau non sacrificiel. A l'étape 105, la partie interne (28a) en matériau sacrificiel est déposée sur le substrat (20), suivie d'un second dépôt en un second matériau recouvrant le matériau sacrificiel (28b). A une étape ultérieure la partie intérieure (28a) de la structure support (25) est retirée et seul reste la partie externe (28b) de la structure support. L'étape de retrait peut être après la formation des éléments thermoélectriques ou après.

La figure 12 illustre un autre procédé de fabrication d'une variante de module thermoélectrique. Le module thermoélectrique (10) diffère de celui de la figure 1 en ce que chaque élément thermoélectrique (11, 12) est formé d'une structure multicouche comportant, de la base vers le sommet, une première couche (11i, 12i) en un premier matériau déposé à l'étape 120a par dépôt sous énergie concentrée comme décrit précédemment, une interface (70) en une couche en un ou plusieurs matériaux formant une barrière de diffusion déposée par tout moyen à l'étape 125, notamment en cuivre ou nickel et une deuxième couche (11ii, 12ii) en un deuxième matériau déposé à l'étape 120b par dépôt sous énergie concentré comme décrit précédemment. L'invention n'est pas limitée à une structure multicouche comportant uniquement deux couches. Une structure plus complexe est possible par dépôt successifs.

L'invention n'est pas limitée aux exemples qui viennent d'être décrits. L'homme du métier saura combiner les enseignements des différents modes de réalisation pour réaliser des variantes non décrites.

Par exemple, les éléments thermoélectriques des figures 1 et 2 peuvent être chacune d'une structure multicouche comme décrit en relation avec la figure 12.

## Revendications

1. Module thermoélectrique (10), comprenant,

   - un substrat (20),
   - au moins deux éléments thermoélectriques (11, 12) adjacents en deux matériaux dopés selon des types de dopages différents s'étendant sur le substrat et reliés électriquement entre eux du côté du substrat (20) et/ou opposé au substrat (20) par une jonction électrique de mélange formée par une couche d'un mélange des deux matériaux dopés selon des types de dopages différents composants les deux éléments thermoélectriques (11, 12).

2. Module thermoélectrique (10) selon la revendication 1, les deux éléments thermoélectriques (11, 12) étant en un même matériau dopés selon des types de dopages différents, notamment dopés respectivement p et n.

3. Module thermoélectrique (10) selon l'une des revendications précédentes, les deux éléments thermoélectriques (10) étant allongés selon un axe longitudinal (X).

4. Module thermoélectrique (10) selon l'une des revendications précédentes, les éléments thermoélectriques (11, 12) étant inclinés sur le substrat (20) par rapport à l'axe perpendiculaire du substrat (20) à leur base dans des directions opposées, notamment d'un angle β compris entre 5° et 70°, l'angle pouvant dépendre des performances thermoélectriques attendues, de la tenue mécanique nécessaire, des matériaux et/ou de la hauteur des éléments.

5. Module thermoélectrique (10) selon l'une des revendications précédentes, la jonction électrique de mélange des deux matériaux composant les deux éléments thermoélectriques s'étendant entre deux surfaces latérales des éléments thermoélectriques (11, 12) en regard.

6. Module thermoélectrique (10) selon l'une des revendications précédentes, la surface de la jonction électrique de mélange selon un plan médian aux deux éléments thermoélectriques (11, 12) étant supérieure ou égale à 50%, mieux supérieure ou égale à 70%, de la surface d'une section transversale d'un élément thermoélectrique.

7. Module selon l'une quelconque des revendications précédentes, comportant une pluralité d'éléments thermoélectriques (11, 12) adjacents reliés électriquement entre eux pour former un circuit thermoélectrique, chaque élément thermoélectrique étant relié électriquement du côté du substrat (20) et/ou opposé au substrat (20) à un autre élément thermoélectrique (11, 12) par une jonction électrique formée par une couche d'un mélange des deux matériaux dopés selon des types de dopages différents composants les deux éléments thermoélectriques (11, 12).

8. Module selon la revendication 7, dans lequel le premier et le dernier élément thermoélectrique du circuit thermoélectrique sont reliés électriquement par une de leurs extrémités à un connecteur électrique et les éléments thermoélectriques entre le premier et le dernier élément thermoélectrique sont tous reliés électriquement à au moins deux éléments thermoélectriques adjacents pour former entre eux le circuit thermoélectrique par des jonctions électriques formées par une couche d'un mélange des deux matériaux dopés selon des types de dopages différents composants les deux éléments thermoélectriques (11, 12).

9. Module selon la revendication 8, dans lequel le premier et le dernier élément thermoélectrique du circuit thermoélectrique sont reliés électriquement par une de leurs extrémités à un connecteur électrique et chaque éléments thermoélectriques entre le premier et le dernier élément thermoélectrique est relié électriquement à au moins deux éléments thermoélectriques adjacents pour former entre eux le circuit thermoélectrique par un connecteur électrique d'un du côté du substrat ou du côté opposé au substrat et par une jonctions électriques formées par une couche d'un mélange des deux matériaux dopés selon des types de dopages différents composants les deux éléments thermoélectriques (11, 12) de l'autre du côté du substrat ou du côté opposé au substrat.

10. Module thermoélectrique (10) selon une des revendications précédentes, les éléments thermoélectriques (11, 12) étant reliés électriquement en série entre eux de l'un du côté du substrat (20) et du côté opposé au substrat (20) uniquement.

11. Module thermoélectrique (10) selon une des revendications précédentes, les éléments thermoélectriques (11, 12) comportant plusieurs couches de matériaux différents dopés avec le même type de dopage, notamment séparées entre elles par des structures d'interface (70).

12. Module thermoélectrique (10) selon une des revendications 1 à 10, au moins deux des éléments thermoélectriques étant reliés électriquement entre eux du côté du substrat et du côté opposé au substrat.

13. Module thermoélectrique (10) selon une des revendications précédentes, le substrat (20) étant de forme cylindrique de base polygonale, notamment rectangle, carré, pentagonale ou hexagonale, circulaire ou elliptique.

14. Module thermoélectrique (10) selon une des revendications précédentes, comportant une structure support sur le substrat, la structure support comportant des éléments supports, notamment en un matériau isolant électriquement, s'étendant entre les éléments thermoélectriques formant entre eux un pont.

[Fig 1]

Fig. 1

[Fig 2]

Fig. 2

[Fig 3]

Fig. 3

[Fig 4]

Fig. 4

[Fig 5]

Fig. 5

[Fig 6]

Fig. 6

[Fig 7]

Fig. 7

[Fig 8]

Fig. 8

[Fig 9]

Fig. 9

[Fig 10]

Fig. 10

[Fig 11]

Fig. 11

[Fig 12]

Fig. 12

Europäisches
Patentamt

European
Patent Office

Office européen
des brevets

## RAPPORT DE RECHERCHE EUROPEENNE

**Numéro de la demande**

EP 25 21 5345

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | MALLICK MD MOFASSER ET AL: "Printed Lateral p-n Junction for Thermoelectric Generation", SMALL SCIENCE, vol. 4, no. 11, 13 août 2024 (2024-08-13), XP093310316, ISSN: 2688-4046, DOI: 10.1002/smsc.202400257 | 1-3,5 | INV. H10N10/17 H10N10/817 H10N10/852 H10N10/851 B33Y80/00 |
| Y | * page 2, colonne de gauche, alinéa 2 - | 7,8 | |
| A | page 7, colonne de gauche, alinéa 4; figures 2-7 * | 4,6,9-14 | |
| | ----- | | |
| Y | US 2015/325765 A1 (IOSAD NIKOLAY [DE]) 12 novembre 2015 (2015-11-12) * alinéa [0024] - alinéa [0032]; figures 1-3 * | 7,8 | |
| | ----- | | |

| | |
|---|---|
| | **DOMAINES TECHNIQUES RECHERCHES (IPC)** |
| | H10N |

Le présent rapport a été établi pour toutes les revendications

| Lieu de la recherche | Date d'achèvement de la recherche | Examinateur |
|---|---|---|
| La Haye | 15 décembre 2025 | Kirkwood, Jonathan |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

..........................................................................

& : membre de la même famille, document correspondant

EPO FORM 1503 03.82 (P04C02)

# EP 4 746 665 A1

## ANNEXE AU RAPPORT DE RECHERCHE EUROPEENNE
## RELATIF A LA DEMANDE DE BREVET EUROPEEN NO.

EP 25 21 5345

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-12-2025

| Document brevet cité au rapport de recherche | Date de publication | Membre(s) de la famille de brevet(s) | Date de publication |
|---|---|---|---|
| US 2015325765 A1 | 12-11-2015 | CN 104956505 A | 30-09-2015 |
| | | EP 2917944 A1 | 16-09-2015 |
| | | US 2015325765 A1 | 12-11-2015 |
| | | WO 2014114366 A1 | 31-07-2014 |

Pour tout renseignement concernant cette annexe : voir Journal Officiel de l'Office européen des brevets, No.12/82

20

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3985745 A
- FR 3140994
- FR 3140993

**Littérature non-brevet citée dans la description**

- **J. LEE** ; **S. CHOO** ; **H. JU** ; **J. HONG** ; **S. E. YANG** ; **F. KIM** ; **D. H. GU** ; **J. JANG** ; **G. KIM** ; **S. AHN**. Doping-Induced Viscoelasticity in PbTe Thermoelectric Inks for 3D Printing of Power-Generating Tubes. *Adv. Energy Mater.*, 2021, vol. 11, 2100190

- **HUE et al.** 3D Printing of Bi2Te3-Based Thermoelectric Materials with High Performance and Shape Controllability. *ACS Applied Materials and Interfaces*, 2023, vol. 15 (32)